(19) Europäisches Patentamt / European Patent Office / Office européen des brevets

(11) **EP 3 570 645 B1**

(12) **EUROPEAN PATENT SPECIFICATION**

(45) Date of publication and mention
of the grant of the patent:
**25.01.2023 Bulletin 2023/04**

(21) Application number: **18172796.7**

(22) Date of filing: **17.05.2018**

(51) International Patent Classification (IPC):
**H05K 1/02** (2006.01)    **H05K 3/42** (2006.01)

(52) Cooperative Patent Classification (CPC):
**H05K 3/423; H05K 1/0206;** H05K 2201/09563;
H05K 2201/0959; H05K 2203/045

(54) **COMPONENT CARRIER WITH ONLY PARTIALLY FILLED THERMAL THROUGH-HOLE**

KOMPONENTENTRÄGER MIT NUR TEILWEISE GEFÜLLTEM THERMISCHEM
DURCHGANGSLOCH

SUPPORT DE COMPOSANT À TROU TRAVERSANT THERMIQUE SEULEMENT PARTIELLEMENT
REMPLI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.11.2019 Bulletin 2019/47**

(73) Proprietor: **AT & S Austria Technologie &
Systemtechnik
Aktiengesellschaft
8700 Leoben-Hinterberg (AT)**

(72) Inventors:
• **Lutschounig, Ferdinand
9170 Ferlach (AT)**

• **Liebfahrt, Sabine
8605 Kapfenberg (AT)**
• **Grober, Gernot
8045 Graz (AT)**
• **Matt, Florian
8263 Großwilfersdorf (AT)**

(74) Representative: **Dilg, Haeusler, Schindelmann
Patentanwaltsgesellschaft mbH
Leonrodstraße 58
80636 München (DE)**

(56) References cited:
**EP-A1- 2 113 587      EP-A1- 2 518 187
WO-A1-2006/032346      US-A1- 2004 124 535
US-A1- 2008 277 155**

## Description

The invention relates to a component carrier and a method of manufacturing a component carrier.

In the context of growing product functionalities of component carriers equipped with one or more electronic components and increasing miniaturization of such components as well as a rising number of components to be mounted on the component carriers such as printed circuit boards, increasingly more powerful array-like components or packages having several components are being employed, which have a plurality of contacts or connections, with ever smaller spacing between these contacts. Focused dissipation of heat generated by such components and the component carrier itself during operation becomes an increasing issue. At the same time, component carriers shall be mechanically robust so as to be operable even under harsh conditions.

Moreover, it may be desired to efficiently manufacture a thermal via of a component carrier while at the same time ensuring a proper heat dissipation.

EP 2 518 187 A1 discloses a component carrier and a method of manufacturing a component carrier according to the preambles of claims 1 and 13, respectively.

US 2004/124535 A1 discloses a substrate with stacked vias and fine circuits and a method for fabricating the substrate are proposed. A core layer is formed with a metal layer respectively on upper and lower surfaces thereof, and at least one through hole. A first insulating layer is applied over the metal layer on the upper surface of the core layer and selectively formed with at least one first opening for exposing the metal layer. A metal layer is formed within the first opening, and a second insulating layer is applied over the first insulating layer and formed with a plurality of second openings, wherein the metal layer within the first opening is exposed via at least one second opening. After a conductive layer is applied over the second insulating layer and within the second openings, a metal layer is formed within the second openings. Finally, the conductive layer is removed by micro-etching.

WO 2006/032346 A1 discloses a galvanic process for filling through-holes with metals. The process is particularly suitable for filling through-holes of printed circuit boards with copper. The process comprises the following steps: (i) formation of a narrow part in the center of a through-hole by electroplating; and (ii) filling the through-hole obtained in step (i) with metal by electroplating.

There may be a need for a component carrier being simple in manufacture while simultaneously ensuring proper heat removal.

This need may be met by the subject matter according to the independent claims. Advantageous embodiments of the present invention are described by the dependent claims.

According to the invention, a component carrier is provided which comprises at least one electrically conductive layer structure and at least one electrically insulating layer structure, a through-hole extending through the at least one electrically insulating layer structure, and highly thermally conductive material filling only part of the through-hole so that a recess is formed which is not filled with the highly thermally conductive material and which extends at least from an outer face of the at least one electrically insulating layer structure into the through-hole. The highly thermally conductive material (108) is copper, which has been filled into the through-hole (106) by means of a plating procedure. A diameter, B, of the recess at a level of the outer face of the at least one electrically insulating layer structure and a width, A, of a web (or another thermal connection portion) of the highly thermally conductive material at the level of the outer face of the at least one electrically insulating layer structure fulfil the conditions B is larger than A and A is larger than B/20.

According to another exemplary embodiment of the invention, a method of manufacturing a component carrier is provided, wherein the method comprises forming a stack comprising at least one electrically conductive layer structure and at least one electrically insulating layer structure, forming a through-hole extending through the at least one electrically insulating layer structure, filling only part of the through-hole with highly thermally conductive material so that a recess is formed which is not filled with the highly thermally conductive material and which extends at least from an outer face of the at least one electrically insulating layer structure into the through-hole, wherein the filling is carried out so that a diameter, B, of the recess at a level of the outer face of the at least one electrically insulating layer structure and a width, A, of a web of the highly thermally conductive material at the level of the outer face of the at least one electrically insulating layer structure fulfil the conditions B is larger than A and A is larger than B/20.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned-types of component carriers.

In the context of the present application, the term "layer structure" may particularly denote a continuous layer, a patterned layer or a plurality of nonconsecutive islands within a common plane.

In the context of the present application, the term "highly thermally conductive material filling only part of the through-hole extending to at least one electrically insulating layer structure" may particularly denote a material which has a significantly higher value of the thermal conductivity than ordinary dielectric material of component carrier stacks. For example, prepreg (as an example for a dielectric material of component carrier stacks) may have a relatively poor thermal conductivity of about 0.3 W/mK. The highly thermally conductive material should have a thermal conductivity of at least several times of this value. For example, the highly thermally conductive material may have a thermal conductivity of at least 3 W/mK, preferably of at least 10 W/mK, more preferably of at least 100 W/mK.

According to an exemplary embodiment of the invention, a component carrier is provided which has a thermal through-hole extending through dielectric component carrier material and being only partially, i.e. not entirely, filled with highly thermally conductive material for heat removal, heat dissipation, heat spreading and/or other kind of thermal management of the component carrier. It has been surprisingly found that a proper removal of heat out of the component carrier neither requires necessarily a (in many cases over-dimensioned) massive copper inlay (as in conventional approaches) nor a thermal via which is really fully filled with copper material. In contrast to this, it has turned out to be sufficient to fill a through-hole extending through an electrically insulating layer structure of the component carrier only partially with highly thermally conductive material (such as copper) while leaving at least one recess adjacent to a thermal access at an outer portion of the through-hole unfilled or free of highly thermally conductive material. If the mentioned recess is properly dimensioned in relation to a thickness of a remaining web of highly thermally conductive material adjacent to the recess, the heat removal properties of the component carrier still comply even with demanding requirements in terms of thermal management. At the same time, an only partial filling of a thermal through-hole with highly thermally conductive material may significantly simplify and accelerate the manufacturing process of the component carrier. A reason for this is that the filling of a through-hole with highly thermally conductive material such as copper usually requires the execution of a sequence of many plating procedures, each of which adding a further portion of the highly thermally conductive material into the through-hole. However, an excessive repetition of such plating procedures renders the manufacturing process cumbersome and involves a high effort. The present inventors have surprisingly found that a design rule, according to which a diameter of the recess at the exterior border of the electrically insulating layer structure penetrated by the through-hole is larger than a width of a remaining web of the highly thermally conductive material at the mentioned height level still allows sufficient heat removal, if the width of the web is not too narrow, in particular is more than 5% or preferably 10% of the diameter of the recess. Manufacturing a component carrier following the mentioned design rule may hence allow keeping the manufacturing effort reasonably low while simultaneously ensuring a highly efficient heat removal capability of the component carrier.

More specifically, an exemplary embodiment of the invention may provide a component carrier with a reliable thermal build up without massive copper inlay. An exemplary embodiment of the invention is based on the finding that a void-free filling is challenging in case of large plated through-holes. The inventors have surprisingly found that sufficiently small exterior voids on top and/or bottom of a plated through-hole do not negatively impact the heat transfer while significantly simplifying the manufacturing procedure. It has turned out that the maximum of heat which can be transferred is predominantly limited by the thermal vias on the upper or lower layers connecting the larger via being partially filled with highly thermally conductive material. Thus, it may be sufficient that the area of the transition copper (corresponding to the web) is bigger than the thermal vias on top and/or on bottom. The recess, sink mark or dimple may extend at least into an electrically conductive layer structure (such as a copper layer) of a top and/or a bottom layer, but can also reach into the electrically insulating layer structure (such as a core) of the component carrier.

For combining an efficient manufacturing process with a proper heat removal capability of the component carrier, it may hence be advantageous to select the diameter, B, of the recess (which may also be denoted as sink mark or dimple) to be larger than the length, A, of a remaining web of the highly thermally conductive material (in particular transition copper on the surface of the core or other electrically insulating layer structure on at least one side). As a further advantageous side effect, an enhanced reliability in terms of interlayer adhesion of a component carrier layer stack may be obtained by increasing the contact surface area of a further (for instance electrically insulating) layer structure extending into the recess. In other words, by filling the mentioned recess(es) with a further electrically insulating layer structure, the adhesion forces between the latter further electrically insulating layer structure and adjacent material may be enhanced due to the increased connection surface. Thus, a gist of an exemplary embodiment of the invention is that there is no need for a complete via-filling, as sought by conventional approaches. In contrast to this, a properly defined partial filling of a thermal through-hole with highly thermally conductive material may be sufficient. Since a connection of laser vias to one or more inner layers of a layer stack of the component carrier can be accomplished much easier by interlayer plating with copper in comparison with an embedding of a macroscopic copper inlay, exemplary embodiments may also render the manufactured component carrier compact without compromising on thermal performance. At the same time, it may be possible to obtain an enhanced intra-stack adhesion.

In the following, further exemplary embodiments of the method and the component carrier will be explained.

In an embodiment, the design rule may require compliance with the more strict condition A is larger than B/10. Following this design rule allows obtaining a specifically pronounced thermal performance while keeping the manufacturing process sufficiently simple.

In an embodiment, a ratio between a vertical height, D, and a maximum horizontal thickness, C, of the through-hole is in a range between 1 and 15, in particular in a range between 1.5 and 10. Since the through-hole is intended for use as a thermal via (in particular substituting a conventional massive copper inlay), the through-hole may extend through an uncommonly thick electrically insulating layer structure and may have the mentioned very high aspect ratio.

In a preferred embodiment, the through-hole is substantially circular cylindrically. Such a cylindrical through-hole may be manufactured by mechanically processing the corresponding one or more electrically insulating layer structures, in particular by mechanically drilling using a rotating drill. Correspondingly, the method may comprise forming the through-hole by mechanically drilling through the at least one electrically insulating layer structure. A mechanical formation of a drilled through-hole is highly advantageous for forming thermal through-holes with uncommonly large size for obtaining a very high thermal performance.

However, it may be alternatively also possible to form the through-hole by laser processing, in particular by laser drilling. In such an embodiment, the shape of the through-hole may deviate from a circular cylindrical shape, for instance may be conically or may be of frustoconical shape (as a consequence of the energy impact of a laser beam in the electrically insulating layer structure).

In an embodiment, a thickness of the at least one electrically insulating layer structure through which the through-hole extends is larger than 400 $\mu$m, in particular is in a range between 600 $\mu$m and 2000 $\mu$m. In other words, the vertical extension of the through-hole filled partially with highly thermally conductive material may be very high, thereby being capable of efficiently transporting heat out of the component carrier during operation.

In an embodiment, a value of the thermal conductivity of the highly thermally conductive material is at least 50 W/mK, in particular is at least 100 W/mK, more particularly is at least 200 W/mK. Most preferred is the use of copper for the highly thermally conductive material, since copper has an extraordinarily high thermal conductivity while simultaneously being properly compatible with component carrier manufacturing technology (in particular PCB technology). Moreover, copper can be properly inserted into a through-hole by plating, in particular by carrying out a sequence of plating procedures.

In accordance with the invention a further recess is formed in the highly thermally conductive material opposing the recess, wherein the further recess is not filled with the highly thermally conductive material and extends at least from another outer face of the at least one electrically insulating layer structure into the through-hole. When an empty through-hole extending through an electrically insulating layer structure and being open at both opposing ends is filled with highly thermally conductive material such as copper by plating, the through-hole filling may start in a central portion of the hole in a first plating procedure. In subsequent plating procedures, filling of the through-hole may then continue along both directions (i.e. upwardly and downwardly) from the central portion. When the filling procedure is terminated before completely filling the through-hole with highly thermally conductive material, this may result in the formation of two opposing recesses at an open bottom and at an open top of the through-hole. According to exemplary embodiments, any property or treatment or design rule or condition disclosed in the present application for the recess may be applied also to the further recess, and *vice versa*.

In an embodiment, a diameter, E, of the further recess at a level of the other outer face of the at least one electrically insulating layer structure and a width, F, of another web of the highly thermally conductive material at the level of the other outer face of the at least one electrically insulating layer structure fulfil the conditions E>F and F>E/20, in particular F>E/10. Thus, the above described design rule for the recess versus the web at an open top end of the through-hole may be applied correspondingly to the further recess and the further web at a bottom end of the through-hole. According to exemplary embodiments, any property or treatment or design rule or condition disclosed in the present application for the web may be applied also to the other web, and *vice versa*.

In an embodiment, B substantially equals E and/or A substantially equals F. More specifically, dimensions and/or shape of the further recess may correspond to dimensions and/or shape of the recess. Accordingly, dimensions and/or shape of the other web may substantially correspond to dimensions and/or shape of the web. This may be the result of a common and symmetric manufacturing procedure in terms of partially filling the through-hole with highly thermally conductive material starting from a center of the through-hole.

In an embodiment, the highly thermally conductive material with the recess and with the further recess is symmetrical with respect to a horizontal plane extending through a center of the at least one electrically insulating layer structure through which the through-hole extends. This allows obtaining spatially homogeneous properties of the component carrier in terms of heat removal performance and also mechanical integrity.

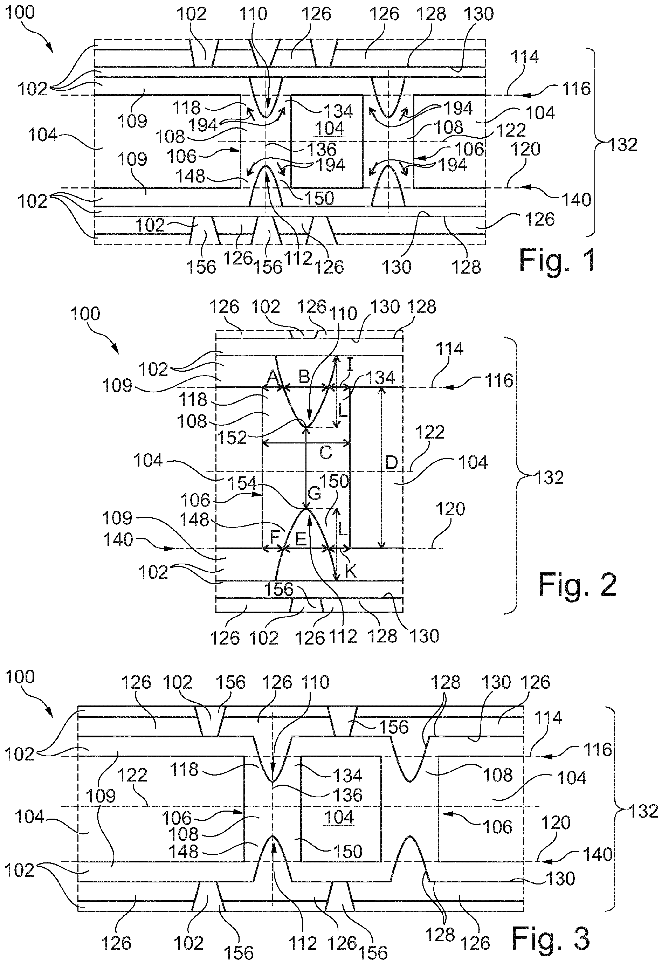

In an embodiment, a cross section of the highly thermally conductive material with the recess and the further recess is a substantially H-shaped structure (compare Figure 1 to Figure 4, Figure 6). Such a highly preferred structure allows efficiently removing heat via thermal paths extending both upwardly and downwardly, each thermal path additionally splitting up heat to propagate around the recess and the further recess, respectively.

In accordance with the invention a ratio between a vertical distance, G, between an innermost end of the recess (i.e. a bottom of the dimple) and an innermost end of the further recess (i.e. a bottom of the further dimple) on the one hand and a height, D, of the through-hole on the other hand is in a range between 30% and 95%, in particular is in a range between 50% and 60%. It has turned out that the mentioned ranges are a proper trade-off between thermal performance on the one hand and a quick and simple manufacturing process on the other hand. For example, the vertical distance, G, may be at least 100 $\mu$m, in particular at least 300 $\mu$m. The entire height, D, may for example be at least 400 $\mu$m, preferably at least 2000 $\mu$m.

In an embodiment, the recess and/or the further recess is filled (in particular partially or entirely) with a dielectric material, in particular a plug paste. Filling up the recess(es) with dielectric material (such as resin) planararizes the component carrier and therefore improves mechanical integrity.

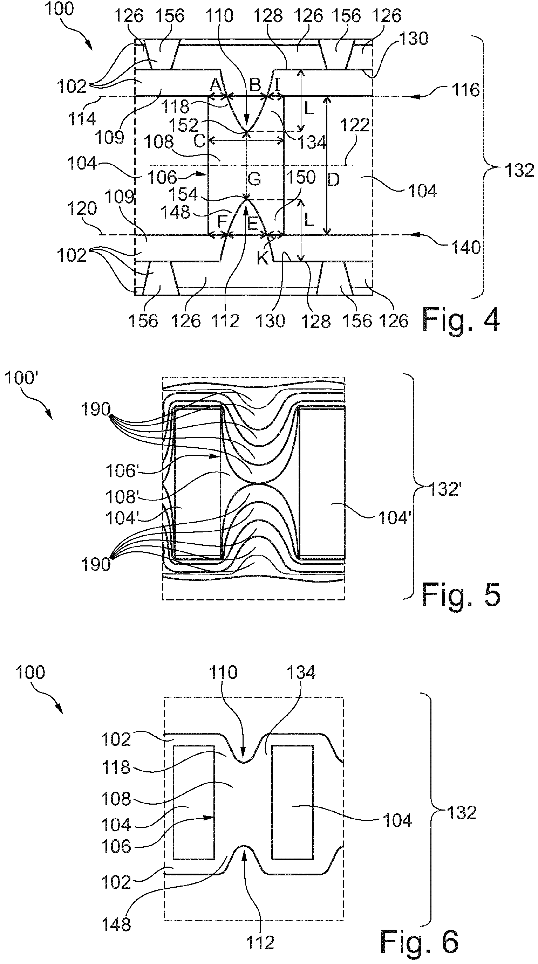

In an embodiment, the component carrier comprises at least one further electrically insulating layer structure. The latter may be connected to an exterior surface of the at least one electrically insulating layer structure, of the at least one electrically conductive layer structure, and/or of further highly thermally conductive material. The at least one further electrically insulating layer structure may fill the recess and/or the further recess, respectively (see for instance Figure 3 and Figure 4). For instance, the at least one further electrically insulating layer structure may comprise an at least partially uncured material (such as prepreg), which can be connected to the layer stack of the component carrier, for instance by lamination (i.e. the application of pressure and/or heat). During such a connection procedure, the at least partially uncured material may be liquefied or re-melted and may start a polymerization or cross-linking reaction. While being temporarily in a liquid or melted state, the mentioned material of the further electrically insulating layer structure may also flow into the recess (and/or the further recess) for filling the latter up. After that, the previously at least partially uncured material may resolidify in a fully cured state.

In an embodiment, an area of a main surface of the at least one further electrically insulating layer structure facing at least one of the recess and the further recess is larger (preferably by 0.1% to 500%) than a hypothetic planar area of said main surface in the absence of the recess or the further recess. When the dielectric layer structure is not only connected to an exterior main surface of the layer stack but also flows into the recess or the further recess, the connection area over which adhesion forces may act may be increased. This improves the mechanical performance of the component carrier.

In another embodiment, the component carrier comprises also at least one further electrically insulating layer structure. The latter may be connected to an exterior surface of the at least one electrically insulating layer structure, the at least one electrically conductive layer structure, and/or further highly thermally conductive material. The at least one further electrically insulating layer structure may be planar (see for instance Figure 1 and Figure 2), and may for instance also cover material of a plug which may fill the recess and/or the further recess. The respective further electrically insulating layer structure may be planar on a main surface thereof facing the recess, i.e. does not extend into the recess in the described embodiment. This planarity may also translate to a planarity on the opposing other main surface of the respective further electrically insulating layer structure. Thus, a flat and planar layer stack may be obtained with such an embodiment.

In an embodiment, the recess may extend through only a part of the electrically insulating layer structure so as to form a blind hole.

In an embodiment, a maximum horizontal thickness, C, of the through-hole is at least 100 $\mu$m. For instance, the maximum horizontal thickness, C, may be in a range between 100 $\mu$m and 700 $\mu$m. Since the through-hole filled partially with highly thermally conductive material is provided for the purpose of promoting the thermal performance of the component carrier, the diameter of the through-hole may be very high.

In an embodiment, a maximum depth of at least one of the recess and the further recess is at least 100 $\mu$m. For example, the maximum depth of the respective recess may be in a range between 100 $\mu$m and 300 $\mu$m. Thus, a significant amount of highly thermally conductive material may lack in the through-hole. This allows manufacturing the component carrier quickly and simply, in particular with a low number of plating procedures. Surprisingly, the heat removal capability is not significantly deteriorated by keeping such relatively large recesses free of highly thermally conductive material.

In an embodiment, the highly thermally conductive material has a further web at the level of the outer face of the at least one electrically insulating layer structure which further web is arranged opposing the web in a horizontal direction and separated from the web by the recess. In other words, the recess may then be located between the web and the further web. In a cross-sectional view, an exterior portion of the through-hole may be composed of the central recess (which may have a substantially parabolic shape, for example with rounded edges) being surrounded on two opposing sides by a respective web or further web. Descriptively speaking, each of the webs may correspond to a heat removal path from an interior to an exterior of the component carrier. In fact, highly thermally conductive material may circumferentially surround the recess or further recess, for instance forming a hollow conical body. According to exemplary embodiments, any property or treatment or design rule or condition disclosed in the present application for the web may be applied also to the further web, and *vice versa*.

In an embodiment, the further web has a width, I, at the level of the outer face of the at least one electrically insulating layer structure fulfilling the conditions B>I and I>B/20, in particular I>B/10. Thus, the above-described design rule concerning the web may also apply to the further web. This may ensure a spatially symmetric and homogeneous heat transfer and may prevent undesired hot spots.

In an embodiment, the web and the further web are arranged symmetrical with respect to a vertical plane extending through a central axis of the through-hole. This architecture allows obtaining a homogeneous heat removal and even heat spreading.

In an embodiment, the highly thermally conductive material in the through-hole is continuously connected via the web (and optionally also via the further web and/or via the other web) with further highly thermally conductive material covering at least part of a main surface of the at least one electrically insulating layer structure. The highly thermally conductive material and the further highly thermally conductive material (copper) may be formed simultaneously by the above described plating procedure(s). It is also possible that such further highly thermally conductive material is also located on the other main surface of the at least one electrically insulating layer structure, connected with one or two webs (which may form part of a circumferential structure) juxtaposed to the further recess.

In an embodiment, the further highly thermally conductive material is shaped as a layer which is interrupted by the recess. In such an embodiment, the recess partially extends into the through hole and particularly traverses the further highly thermally conductive material. Additionally or alternatively, still another highly thermally conductive material shaped as a further layer may be interrupted, traversed or penetrated by the further recess. Thus, the mentioned additional highly thermally conductive material may be arranged on one or both of the two opposing main surfaces of the electrically insulating layer structure through which the through-hole extends.

It should be mentioned that also the further recess may be circumferentially surrounded by the highly thermally conductive material, which corresponds to the presence of two webs in a cross-sectional view thereof.

In an embodiment, the method comprises filling the through-hole only partially with the highly thermally conductive material by carrying out a number of sequential plating procedures. For instance, the plating procedures may be terminated upon fulfilling the above-described conditions B>A and A>B/20 and, if applicable, the above-described condition B>I and I>B/20, etc.

As mentioned above, at least one component may be surface mounted on and/or embedded in the component carrier. For instance, such a component may be a heat source during operation of the component carrier. The heat generated by such a component may be removed from the component carrier also by the highly thermally conductive material partially filling the through-hole. More generally, at least one component which may be embedded in and/or surface mounted on the component carrier can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, a light guide, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite base structure) or may be a paramagnetic element. However, the component may also be a further component carrier, for example in a board-in-board configuration. One or more components may be surface mounted on the component carrier and/or may be embedded in an interior thereof. Moreover, also other than the mentioned components may be used as component.

In an embodiment, the component carrier comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, dielectric material of the at least one electrically insulating layer structure and/or at least one further electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, electrically conductive material of the electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type body. In such an embodiment, the semifinished product or the component carrier is a compound of multiple layer structures which are stacked and connected together by applying a pressing force, if desired accompanied by heat.

In an embodiment, the component carrier has a copper layer as central element in the middle of the stack-up.

In an embodiment, the component carrier has a resin-based layer as central element in the middle of the stack-up.

The aspects defined above and further aspects of the invention are apparent from the examples of embodiment to be described hereinafter and are explained with reference to these examples of embodiment.

Figure 1 illustrates a cross-sectional view of a component carrier according to an exemplary embodiment of the invention.
Figure 2 illustrates a detailed view of a region of and around a through-hole of the component carrier according to Figure 1.
Figure 3 illustrates a cross-sectional view of a component carrier according to another exemplary embodiment of the invention.
Figure 4 illustrates a detailed view of a region of and around a through-hole of the component carrier according to Figure 3.
Figure 5 illustrates a cross-sectional view of a portion of a component carrier with a fully copper filled through-hole.
Figure 6 illustrates a cross-sectional view of a portion of a component carrier according to an exemplary embodiment of the invention with an only partly copper filled through-hole.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a component carrier with a reliable thermal build up is provided without massive copper inlay.

In many cases, copper inlays are used for massive heat transfer within a component carrier. However, such copper inlays are in many cases oversized, as the bottleneck of a heat transfer from one side to the other is frequently a number of thermal vias connecting the inlay with the heat generating unit (such as an embedded component, like a chip, for instance a processor). Secondly, the usage of copper inlays is expensive and involves a resource consuming embedding procedure.

A gist of an exemplary embodiment of the invention is the replacement or supplementation of one or more copper inlays with plated through-holes designed in a specific manner. In particular, one or more of such through-holes may be filled partially with a highly thermally conductive material (such as copper) for proper heat transfer from top to bottom of the component carrier. With the highly thermally conductive filling according to an exemplary embodiment of the invention, it may be possible to replace conventionally used copper inlays inside a component carrier (such as a printed circuit board, PCB). Such a partial filling of through-holes with highly thermally conductive material may leave one or more recesses or voids inside on top and/or on bottom of the plated through-hole. In terms of improving heat transfer while keeping the manufacturing process simple, an exemplary embodiment of the invention replaces or supplements a conventional copper inlay with one or more copper-plated through-holes (which may also be denoted as thermal vias). In particular when such through-holes, being partially filled with highly thermally conductive material such as copper, have a sufficiently large diameter (for instance more than 100 $\mu$m), a component carrier with a high thermal performance may be obtained.

It has also turned out that exemplary embodiments of the invention simultaneously allow achieving a reliable mechanical connection of a further electrically insulating layer structure with an electrically conductive layer structure (such as a copper structure) by increasing the surface area of the insulating layer. This may be achieved by inserting material of the further electrically insulating layer structure in the mentioned recess, which increases the connection area.

An advantageous process for such kind of build-up is a plating process to be carried out for filling the through-hole with highly thermally conductive material such as copper. A conventionally desired complete void free filling of vias with a large diameter is however challenging. Advantageously, an exemplary embodiment of the invention renders its dispensable to completely fill a through-hole or via, as the present inventors have found that the maximum of heat which can be transferred is mainly limited by the thermal vias on the upper or lower layers connecting the large via. As a consequence, it is sufficient that the area of the transition copper is bigger than the thermal vias on top. This can lead to a build-up, where the recess (or sink mark or dimple) extends into an electrically conductive layer structure (such as a copper layer) from a top and/or a bottom layer. However, it can also reach into a core (or another electrically insulating layer structure) of a stack of layer structures of the component carrier. In any case, it may be highly advantageous that there is at least one bridge of thermally highly conductive materials (in particular a copper bridge) in the through-hole.

If a plain surface is desired at an exterior side of the through-hole, it is also possible to plug the dimple with a paste, an ink or something similar. Such a plug material may be electrically insulating and/or electrically conductive and/or may be thermally conductive or thermally insulating.

According to another aspect of an exemplary embodiment of the invention, an enhanced reliability in terms of a strong connection or adhesion between a further electrically insulating layer structure (such as an insulating layer which may for example be made of a resin, if desired additionally comprising reinforcing particles such as glass fibers) and an electrically conductive layer structure (such as a copper layer) may be obtained thanks to the mentioned recess in the through-hole. This can be achieved by increasing the surface area of the insulating material by extending the latter into the recess. In this context, a further obtainable advantage is a certain nonplanarity achieved by not completely filling of vias.

While conventional approaches intend to have planar filled plated through-holes, exemplary embodiments of the invention are based on a design with a not planar copper-filled plated through-hole.

If desired, a final planarity may be achieved by laminating a further electrically insulating layer structure also into the recess (for instance with prepreg) and/or by plugging or grinding. Connecting a further electrically insulating layer (for instance laminating prepreg) may allow obtaining a better adhesion of an upper and/or a lower (for instance prepreg) dielectric layer to a copper-filled plated through-hole. By plugging, a connection of laser vias to an inner layer may be realized easier than with a plating of an inner layer with copper.

Exemplary applications of exemplary embodiments of the invention include component carriers having embedded and/or surface mounted at least one heat generating component such as a MOSFET (metal oxide semiconductor field effect transistor), an LED (light emitting diode), etc. Thus, a component carrier with highly advantageous thermal performance may be obtained which is also very reliable in terms of mechanical integrity.

**Figure 1** illustrates a cross-sectional view of a component carrier 100, which is embodied as a flat planar laminate-type printed circuit board (PCB), according to an exemplary embodiment of the invention. **Figure 2** illustrates a detailed view of a region of and around a through-hole 106 of the component carrier 100 according to Figure 1.

The component carrier 100 illustrated in Figure 1 comprises a stack 132 with a central electrically insulating layer structure 104. The electrically insulating layer structure 104 may for example be a core comprising fully cured resin material such as epoxy resin. Optionally, the electrically insulating layer structure 104 may additionally comprise reinforcing particles such as glass fibers. For example, the electrically insulating layer structure 104 may be made of FR4 material. The electrically insulating layer structure 104 has an extraordinarily large vertical height, D, as shown in Figure 2. For instance, D may be 1000 $\mu$m. It is also possible that the electrically insulating layer structure 104 is composed of multiple dielectric layers, and it is possible that one or more electrically conductive layers are in between such multiple dielectric layers (not shown).

A vertically extending through-hole 106 extends vertically through the entire electrically insulating layer structure 104. The through-hole 106 may be formed by a mechanical drilling process. As a result of this mechanical drilling process, the through-hole 106 has vertical sidewalls and has a substantially circular cylindrical shape. In view of its large height, D, or for example 1000 $\mu$m and its very large horizontal thickness, C, of for instance 500 $\mu$m, an aspect ratio (i.e. a ratio between D and C) of the through-hole 106 is about 2 in the shown embodiment.

Each of two opposing main surfaces of the electrically insulating layer structure 104 is covered with a respective electrically conductive layer structure 102, which may be formed for instance by plated copper material.

Copper as a highly thermally conductive material 108 fills only part of the through-hole 106. More specifically, the through-hole 106 is partially filled with the highly thermally conductive material 108 and comprises a recess 110 at an upper open end of the through-hole 106 as well as a further recess 112 at an open lower end of the through-hole 106. Both the recess 110 and the further recess 112 are free of highly thermally conductive material 106. Thus, the recess 110 with substantially parabolic shape in the cross-sectional view of Figure 1 and Figure 2 is formed as not being filled with the highly thermally conductive material 108. The recess 110 extends partially from an upper outer face 114 of the electrically insulating layer structure 104 downwardly into the through-hole 106. Another part of the recess 110 extends from the upper outer face 114 upwardly through the electrically conductive layer structure 102 being directly applied on the upper main surface of the electrically insulating layer structure 104 up to a further electrically conductive layer structure 102 (such as a copper foil). Correspondingly, the further recess 112 with substantially parabolic shape in the cross-sectional view of Figure 1 and Figure 2 is formed as not being filled with the highly thermally conductive material 108. The further recess 112 extends partially from a lower outer face 120 of the electrically insulating layer structure 104 upwardly into the through-hole 106. Another part of the further recess 112 extends from the lower outer face 120 downwardly through the electrically conductive layer structure 102 being directly applied on the lower main surface of the electrically insulating layer structure 104 up to a further electrically conductive layer structure 102 (such as a copper foil).

As shown in Figure 2, a diameter, B, of the recess 110 at a vertical level 116 of the outer face 114 of the electrically insulating layer structure 104 and a width, A, of a web 118 (or connection portion) of the highly thermally conductive material 108 at the level 116 of the outer face 114 of the electrically insulating layer structure 104 fulfil the following two conditions or design rules:

$$B > A$$

and

$$A > B/20 \text{ (preferably } A > B/10)$$

"B" may also be denoted as diameter of dimple or recess 110 at the upper end of the electrically insulating layer structure 104. "A" may also be denoted as horizontal length of a transition portion (more specifically of transition copper) of the highly thermally conductive material 108 juxtaposed to and thereby delimiting dimple or recess 110 at the upper end of the electrically insulating layer structure 104. Thus, the diameter, B, of the recess 110 (embodied as a sink mark or dimple) at height level 116 is larger than the length, A, of the transition copper on the surface of the core-type electrically insulating layer structure 104. Plugged voids in form of recess 110 and further recess 112 reach into the core-area. In alternative embodiments, plugged voids are only smaller deepenings in the copper, i.e. are more shallow than the recess 110 and the further recess 112 in Figure 1 and Figure 2.

According to the preferred design rules of the present embodiment, a diameter, E, of the further recess 112 at vertical level 140 of the other outer face 120 of the electrically insulating layer structure 104 and a width, F, of another web 148 of the highly thermally conductive material 108 at the level 140 of the other outer face 120 of the electrically insulating layer structure 104 fulfil the conditions:

$$E > F$$

and

$$F > E/20 \text{ (preferably } F > E/10\text{)}$$

Moreover, the following conditions are fulfilled in the shown embodiment:

$$A \approx F$$

and

$$B \approx E$$

Thus, a very symmetric configuration of the highly thermally conductive material 108 is obtained.

As can be taken from Figure 1 and Figure 2 as well, the highly thermally conductive material 108 has a further web 134 at the level 116 of the upper outer face 114 of the electrically insulating layer structure 104. The further web 134 is arranged opposing the web 118 in a horizontal direction and is separated from the web 118 by the recess 110. The web 118 of the further web 134 are different sections of a circumferentially closed or connected portion of the highly thermally conductive material 108 surrounding the recess 110. Descriptively speaking, the heat flow from an interior of the component carrier 120 to an exterior thereof may be via the webs 118, 134 around recess 110 (and correspondingly via webs 148, 150 around recess 112). This is indicated schematically by arrows 194 in Figure 1. Thus, multiple heat dissipation paths are formed via which heat can be removed efficiently.

Again referring to Figure 2, the further web 134 has a width, I, at the level 116 of the outer face 114 of the electrically insulating layer structure 104 fulfilling the additional design rules or conditions:

$$B > I$$

and

$$I > B/20 \text{ (preferably } I > B/10\text{)}$$

The web 118 and the further web 134 (and correspondingly webs 148, 150) are arranged symmetrical with respect to a vertical plane 136 extending through a central axis of the through-hole 106.

As can be taken from Figure 1 and Figure 2 as well and as already mentioned above, the highly thermally conductive material 108 has yet another web 150 at the level 140 of the lower outer face 120 of the electrically insulating layer structure 104. The other web 150 is arranged opposing the web 148 in a horizontal direction and is separated from the web 148 by the further recess 112. The web 148 and the further web 150 are different sections of a circumferentially closed or connected portion of the highly thermally conductive material 108 surrounding the further recess 112.

As can be taken from Figure 2, the other web 150 has a width, K, at the level 140 of the lower outer face 120 of the electrically insulating layer structure 104 fulfilling the additional design rules or conditions:

$$E > K$$

and

$$K > E/20 \text{ (preferably } K > E/10\text{)}$$

The web 148 and the further web 150 are arranged symmetrical with respect to the vertical plane 136.

Referring to Figure 1, the highly thermally conductive material 108 with the recess 110 and with the further recess 112 is symmetrical with respect to a horizontal plane 122 extending through a vertical center of the electrically insulating layer structure 104 through which the through-hole 106 extends. In view of the described symmetry, a cross section of the highly thermally conductive material 108 with the recess 110 and the further recess 112 is a substantially H-shaped structure. This shape combines an efficient heat removal with a simple manufacturability.

As a further design rule, a ratio between a vertical distance, G, between an innermost end 152 of the recess 110 and an innermost end 154 of the further recess 112 on the one hand and height, D, of the through-hole 106 on the other hand maybe around 60%. This also contributes to a proper thermal performance and a simple manufacturability. The mentioned percentage may however also be significantly larger, or may be smaller. For instance, the maximum depth, L, of the recess 110 and the further recess 112 may be 100 $\mu$m or larger.

In the embodiment of Figure 1 and Figure 2, both the recess 110 and the further recess 112 are filled with a dielectric plug paste (such as a resin). This planarizes the exterior surfaces of the layer stack before the next electrically conductive layer structures 102 are connected (in particular by lamination) both at the top side and the bottom side.

Again referring to Figure 1 and Figure 2, the component carrier 100 comprises both on the top side and on the bottom side a respective further electrically insulating layer structure 126 connected to an exterior surface 128 of the latter mentioned electrically conductive layer structures 102 on the electrically insulating layer structure 104. A respective main surface 130 of the respective further electrically conductive layer structures 102 is planar.

As shown in Figure 1, multiple thermal through-holes 106 with the described properties may be arranged in parallel and laterally spaced from one another in the electrically insulating layer structure 104. This further promotes the thermal performance.

A method of manufacturing the component carrier 100 according to Figure 1 and Figure 2 may be as follows: First of all, the through-holes 108 may be mechanically drilled in the electrically insulating layer structure 104. Thereafter, the through-holes 106 are partially filled with the highly thermally conductive material 108. This filling procedure is executed by carrying out a number of plating procedures, wherein the plating procedures are terminated upon fulfilling the above-described design rules or conditions (such as B>A and A>B/20). During this plating procedure, not only the through-hole 106 is partially filled with the copper material constituting the highly thermally conductive material 108, but copper material may also be deposited on the exposed exterior surfaces of the electrically insulating layer structure 104. In other words, the electrically conductive layer structures 102 formed directly on the two opposing main surfaces of the electrically insulating layer structure 104 may be formed by plating. The recesses 110, 112 remaining after plating may then be filled with the plug material (for instance resin). After that, the further electrically conductive layer structures 102 and the further electrically insulating layer structures 126 may be connected, for instance by lamination. Laser vias 156 may be formed and filled with copper, for instance by plating.

As can be taken best from Figure 1, the highly thermally conductive material 108 (copper in the shown embodiment) in the through-hole 106 is continuously connected at a top side via the web 118 and the further web 134 with further highly thermally conductive material 109 (also copper in the shown embodiment) covering an upper main surface of the electrically insulating layer structure 104. Correspondingly, the highly thermally conductive material 108 in the through-hole 106 is continuously connected at a bottom side via the web 148 and the web 150 with further highly thermally conductive material 109 covering a lower main surface of the electrically insulating layer structure 104. The highly thermally conductive material 108 as well as the further highly thermally conductive material 109 may be produced simultaneously by the above-described plating procedures. The further highly thermally conductive material 109 is shaped as a respective layer on a respective one of the two opposing main surfaces of the electrically insulating layer structure 104. The further highly thermally conductive material 109 on top side of the electrically insulating layer structure 104 is interrupted by the recess 110. The further highly thermally conductive material 109 on the bottom side of the electrically insulating layer structure 104 is interrupted by the further recess 112.

**Figure 3** illustrates a cross-sectional view of a component carrier 100 according to another exemplary embodiment of the invention. **Figure 4** illustrates a detailed view of a region of and around a through-hole 106 of the component carrier 100 according to Figure 3.

According to the embodiment of Figure 3 and Figure 4, the component carrier 100 comprises further electrically insulating layer structures 126 laminated to an exterior surface 128 of the highly thermally conductive material 108 and the further highly thermally conductive material 109. During the lamination, material of the further electrically insulating layer structures 106 also flows into the recess 110 and the further recess 112 and fills the latter. Due to the concave shape of the recess 110 and the further recess 112, a connection area of a main surface 130 of the further electrically insulating layer structures 126 facing the recess 110 and the further recess 112, respectively, is larger by several percent than a hypothetic area of said main surface 130 in the absence of the recess 110 or the further recess 112. This may allow obtaining a reliable connection of the further insulating layer and adjacent copper material by increasing the surface area of the further electrically insulating layer structures 126. The area of the further electrically insulating layer structures 126 may for example be 0.1 % to 500 % bigger than the surface of a corresponding planar insulting layer. The partial raising of the further electrically insulating layer structures 126 can be for example at least 0.2 $\mu$m or can even reach up to the half of a core thickness. Thus, the embodiment of Figure 3 and Figure 4 uses voids filled with insulating material (of the upper layer) reaching into the core-area.

As an alternative to the embodiment of Figure 3 and Figure 4, only smaller deepenings may be formed in the copper-layer filled with insulating material.

**Figure 5** illustrates a cross-sectional view of a portion of a component carrier 100' with a fully copper filled through-hole 106'.

Figure 5 shows the individual copper sections in the through-hole 106' forming the highly thermally conductive material 108'. Each individual copper section is formed by a respective plating procedure. In the conventional architecture according to Figure 5, the number of executed plating procedures is so large that no recesses remain in the through-hole 106', as the entire through-hole 106' is filled with highly thermally conductive material 108'. In Figure 5, curved layers 190 illustrate copper portions formed in a respective plating procedure.

**Figure 6** illustrates a cross-sectional view of a portion of a component carrier 100 manufactured according to an exemplary embodiment of the invention with an only partly copper filled through-hole 106.

In contrast to the conventional approach according to Figure 5, an exemplary embodiment of the invention intentionally stops the plating procedures before the entire through-hole 106 is completely filled with highly thermally conductive material 106. The result of such a manufacturing process is shown in Figure 6.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

**Claims**

1. A component carrier (100), wherein the component carrier (100) comprises:

   at least one electrically conductive layer structure (102) and at least one electrically insulating layer structure (104);
   a through-hole (106) extending through the at least one electrically insulating layer structure (104);
   highly thermally conductive material (108) filling only part of the through-hole (106) so that a recess (110) is formed which is not filled with the highly thermally conductive material (108) and which extends at least from an outer face (114) of the at least one electrically insulating layer structure (104) into the through-hole (106);
   wherein the highly thermally conductive material (108) is copper, which has been filled into the through-hole (106) by means of a plating procedure;
   wherein a diameter, B, of the recess (110) at a level (116) of the outer face (114) of the at least one electrically insulating layer structure (104) and a width, A, of a web (118) of the highly thermally conductive material (108) at the level (116) of the outer face (114) of the at least one electrically insulating layer structure (104) fulfil the conditions B>A and A>B/20; and
   wherein a further recess (112) is formed in the highly thermally conductive material (108) opposing the recess (110), wherein the further recess (112) is not filled with the highly thermally conductive material (108) and extends at least from another outer face (120) of the at least one electrically insulating layer structure (104) into the through-hole (106),
   **characterized in that**
   a ratio between a vertical distance, G, between an innermost end (152) of the recess (110) and an innermost end (154) of the further recess (112) on the one hand and a height, D, of the through-hole (106) on the other hand is in a range between 30% and 95%, in particular is in a range between 50% and 60%.

2. The component carrier (100) according to claim 1, comprising at least one of the following features:

   wherein A>B/10, in particular A>B/5;
   wherein a ratio between a vertical height, D, and a maximum horizontal thickness, C, of the through-hole (106) is in a range between 1 and 15, in particular in a range between 1.5 and 10;
   wherein the through-hole (106) is substantially circular cylindrically;
   wherein a thickness of the at least one electrically insulating layer structure (104) through which the through-hole (106) extends is larger than 400 μm, in particular is in a range between 600 μm and 2000 μm;
   wherein a value of the thermal conductivity of the highly thermally conductive material (108) is at least 50 W/mK, in particular is at least 100 W/mK, more particularly is at least 200 W/mK.

3. The component carrier (100) according to claim 1 or 2, comprising at least one of the following features:

   wherein a diameter, E, of the further recess (112) at a level (140) of the other outer face (120) of the at least one electrically insulating layer structure (104) and a width, F, of another web (148) of the highly thermally conductive material (108) at the level (140) of the other outer face (120) of the at least one electrically insulating layer structure (104) fulfil the conditions E>F and F>E/20, in particular F>E/10, wherein B in particular substantially equals E and/or A substantially equals F;
   wherein the highly thermally conductive material (108) together with the recess (110) and with the further recess (112) form a symmetric structure with respect to a horizontal plane (122) extending through a center of the at least one electrically insulating layer structure (104) through which the through-hole (106) extends;
   wherein a cross section of the highly thermally conductive material (108) together with the recess (110) and the further recess (112) along a vertical plane is a substantially H-shaped structure.

4. The component carrier (100) according to any of claims 1 to 3, comprising at least one of the following features:

   wherein at least one of the group consisting of the recess (110) and the further recess (112) is filled with a dielectric material, in particular at least one of a plug paste and/or resin;
   comprising at least one further electrically insulating layer structure (126) connected to an exterior surface (128) of at least one of the at least one electrically insulating layer structure (104), the at least one electrically conductive layer structure (102), and further highly thermally conductive material (109), wherein the at least one further electrically insulating layer structure (126) fills at least one of the recess (110) and the further recess (112), wherein in particular an area of a main surface (130) of the at least one further electrically insulating layer structure (126) facing at least one of the recess (110) and the further recess (112) is larger, in particular by 0.1% to 500%, than a hypothetic area of said main surface (130) in the absence of the recess (110) or the further recess (112); comprising at least one further electrically insulating layer structure (126) connected to an exterior surface (128) of at least one of the at least one electrically insulating layer structure (104), the at least one electrically conductive layer structure (102), and further highly thermally conductive material (109), wherein the at least one further electrically insulating layer structure (126) is planar.

5. The component carrier (100) according to any of claims 1 to 4, wherein a maximum horizontal thickness, C, of the through-hole (106) is at least 100 $\mu$m.

6. The component carrier (100) according to claims 1 to 5, wherein a maximum depth (L) of at least one of the recess (110) and the further recess (112) is at least 100 $\mu$m.

7. The component carrier (100) according to claims 1 to 6, wherein the highly thermally conductive material (108) has a further web (134) at the level (116) of the outer face (114) of the at least one electrically insulating layer structure (104), wherein the further web (134) is arranged opposing the web (118) in a horizontal direction so that the recess (110) is located between the web (118) and the further web (134).

8. The component carrier (100) according to claim 7, wherein the further web (134) has a width, I, at the level (116) of the outer face (114) of the at least one electrically insulating layer structure (104) fulfilling the conditions B>I and I>B/20, in particular I>B/10.

9. The component carrier (100) according to claim 7 or 8, wherein the web (118) and the further web (134) are arranged symmetric with respect to a vertical plane (136) extending through a central axis of the through-hole (106).

10. The component carrier (100) according to claims 1 to 9, wherein the highly thermally conductive material (108) in the through-hole (106) is continuously connected via the web (118) with further highly thermally conductive material (109) covering at least part of a main surface of the at least one electrically insulating layer structure (104).

11. The component carrier (100) according to claim 10, wherein the further highly thermally conductive material (109) is shaped as a layer which is interrupted by the recess (110).

12. The component carrier (100) according to claims 1 to 11, comprising at least one of the following features:

the at least one electrically conductive layer structure (102) comprises at least one of the group consisting of copper, aluminum, nickel, silver, gold, palladium, and tungsten, any of the mentioned materials being optionally coated with supra-conductive material such as graphene;
the at least one electrically insulating layer structure (104) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide;
the component carrier (100) comprises at least one embedded and/or at least one surface mounted component, wherein the at least one component is in particular selected from a group consisting of an electronic component, an electrically non-conductive and/or electrically conductive inlay, a heat transfer unit, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, an antenna, a magnetic element, a light guiding element, a further component carrier (100) and a logic chip;
the component carrier (100) is shaped as a plate;
the component carrier (100) is configured as a printed circuit board, or an IC substrate.

13. A method of manufacturing a component carrier (100), wherein the method comprises:

forming a stack (132) comprising at least one electrically conductive layer structure (102) and at least one electrically insulating layer structure (104);
forming a through-hole (106) extending through the at least one electrically insulating layer structure (104);

filling, by means of a plating procedure, only part of the through-hole (106) with highly thermally conductive material (108) so that a recess (110) is formed which is not filled with the highly thermally conductive material (108), and a further recess (112), which is not filled with the highly thermally conductive material (108), is formed opposing the recess (110), wherein the recess (110) extends at least from an outer face (114) of the at least one electrically insulating layer structure (104) into the through-hole (106) and the further recess (112) extends at least from another outer face (120) of the at least one electrically insulating layer structure (104) into the through-hole (106),

wherein the highly thermally conductive material (108) is copper;

wherein the filling is carried out so that a diameter, B, of the recess (110) at a level (116) of the outer face (114) of the at least one electrically insulating layer structure (104) and a width, A, of a web (118) of the highly thermally conductive material (108) at the level (116) of the outer face (114) of the at least one electrically insulating layer structure (104) fulfil the conditions B>A and A>B/20, **characterized in that**

the filling is carried out so that a ratio between a vertical distance, G, between an innermost end (152) of the recess (110) and an innermost end (154) of the further recess (112) on the one hand and a height, D, of the through-hole (106) on the other hand is in a range between 30% and 95%, in particular is in a range between 50% and 60%.

14. The method according to claim 13, comprising at least one of the following features:

wherein the method comprises forming the through-hole (106) by mechanically drilling through the at least one electrically insulating layer structure (104);

wherein the method comprises filling the through-hole (106) only partially with the highly thermally conductive material (108) by carrying out a plurality of plating procedures, wherein the plating procedures are terminated as soon as the conditions B>A and A>B/20 are fulfilled.

**Patentansprüche**

1. Ein Komponententräger (100), wobei der Komponententräger (100) aufweist:

mindestens eine elektrisch leitfähige Schichtstruktur (102) und mindestens eine elektrisch isolierende Schichtstruktur (104);

eine Durchgangsöffnung (106), welche sich durch die mindestens eine elektrisch isolierende Schichtstruktur (104) erstreckt;

ein stark thermisch leitfähiges Material (108), welches nur einen Teil der Durchgangsöffnung (106) füllt, so dass eine Aussparung (110) gebildet ist, welche nicht mit dem stark thermisch leitfähigen Material (108) gefüllt ist und welche sich mindestens von einer äußeren Fläche (114) der mindestens einen elektrisch isolierenden Schichtstruktur (104) in die Durchgangsöffnung (106) erstreckt;

wobei das stark thermisch leitfähige Material (108) Kupfer ist, welches mittels einer Plattierungsprozedur in die Durchgangsöffnung (106) gefüllt wurde;

wobei ein Durchmesser, B, der Aussparung (110) bei einer Ebene (116) der äußeren Fläche (114) der mindestens einen elektrisch isolierenden Schichtstruktur (104) und eine Breite, A, eines Netzes (118) aus dem stark thermisch leitfähigen Material (108) bei der Ebene (116) der äußeren Fläche (114) der mindestens einen elektrisch isolierenden Schichtstruktur (104) die Bedingungen B > A und A > B/20 erfüllt; und

wobei eine weitere Aussparung (112) in dem stark thermisch leitfähigen Material (108) gegenüber der Aussparung (110) gebildet ist, wobei die weitere Aussparung (112) nicht mit dem stark thermisch leitfähigen Material (108) gefüllt ist und sich zumindest von einer anderen äußeren Fläche (120) der mindestens einen elektrisch isolierenden Schichtstruktur (104) in die Durchgangsöffnung (106) erstreckt,

**dadurch gekennzeichnet, dass**

ein Verhältnis zwischen einem vertikalen Abstand, G, zwischen einem innersten Ende (152) der Aussparung (110) und einem innersten Ende (154) der weiteren Aussparung (112) einerseits und einer Höhe, D, der Durchgangsöffnung (106) andererseits in einem Bereich zwischen 30 % und 95 % ist, insbesondere in einem Bereich zwischen 50 % und 60 % ist.

2. Der Komponententräger (100) gemäß Anspruch 1, aufweisend mindestens eines der folgenden Merkmale:

wobei A > B/10, insbesondere A > B/5;

wobei ein Verhältnis zwischen einer vertikalen Höhe, D, und einer maximalen horizontalen Dicke, C, der Durchgangsöffnung (106) in einem Bereich zwischen 1 und 15 ist, insbesondere in einem Bereich zwischen 1,5 und 10 ist;

wobei die Durchgangsöffnung (106) im Wesentlichen kreiszylindrisch ist;

wobei eine Dicke der mindestens einen elektrisch isolierenden Schichtstruktur (104), durch welche sich die Durchgangsöffnung (106) erstreckt, größer als 400 $\mu$m ist, insbesondere in einem Bereich zwischen 600 $\mu$m und 2000 $\mu$m ist;

wobei ein Wert der thermischen Leitfähigkeit des stark thermisch leitfähigen Materials (108) mindestens 50 W/mK ist, insbesondere mindestens 100 W/mK ist, weiter insbesondere mindestens 200 W/mK ist.

3. Der Komponententräger (100) gemäß Anspruch 1 oder 2, aufweisend mindestens eines der folgenden Merkmale:

wobei ein Durchmesser, E, der weiteren Aussparung (112) bei einer Ebene (140) der anderen äußeren Fläche (120) der mindestens einen elektrisch isolierenden Schichtstruktur (104) und eine Breite, F, eines anderen Netzes (148) des stark thermisch leitfähigen Materials (108) bei der Ebene (140) der anderen äußeren Fläche (120) der mindestens einen elektrisch isolierenden Schichtstruktur (104) die Bedingungen E > F und F > E/20, insbesondere F > E/10 erfüllt, wobei B insbesondere im Wesentlichen gleich E ist und/oder A im Wesentlichen gleich F ist;

wobei das stark thermisch leitfähige Material (108) zusammen mit der Aussparung (110) und mit der weiteren Aussparung (112) eine symmetrische Struktur in Bezug auf eine horizontale Ebene (122) bildet, welche sich durch eine Mitte der mindestens einen elektrisch isolierenden Schichtstruktur (104) erstreckt, durch welche sich die Durchgangsöffnung (106) erstreckt;

wobei ein Querschnitt des stark thermisch leitfähigen Materials (108) zusammen mit der Aussparung (110) und der weiteren Aussparung (112) entlang einer vertikalen Ebene eine im Wesentlichen H-förmige Struktur ist.

4. Der Komponententräger (100) gemäß einem beliebigen der Ansprüche 1 bis 3, aufweisend mindestens eines der folgenden Merkmale:

wobei mindestens eines aus der Gruppe, bestehend aus der Aussparung (110) und der weiteren Aussparung (112), mit einem dielektrischen Material gefüllt ist, insbesondere mindestens einem von einer Verschlusspaste und/oder einem Harz;

aufweisend mindestens eine weitere elektrisch isolierende Schichtstruktur (126), welche mit einer Außenfläche (128) von mindestens einem von der mindestens einen elektrisch isolierenden Schichtstruktur (104), der mindestens einen elektrisch leitfähigen Schichtstruktur (102), und einem weiteren stark thermisch leitfähigen Material (109) verbunden ist, wobei die mindestens eine weitere elektrisch isolierende Schichtstruktur (126) mindestens eine der Aussparung (110) und der weiteren Aussparung (112) füllt, wobei insbesondere eine Fläche einer Hauptoberfläche (130) der mindestens einen weiteren elektrisch isolierenden Schichtstruktur (126), welche mindestens einer der Aussparung (110) und der weiteren Aussparung (112) zugewandt ist, größer ist, insbesondere um 0,1 % bis 500 %, als eine hypothetische Fläche der Hauptoberfläche (130) bei einer Abwesenheit der Aussparung (110) oder der weiteren Aussparung (112);

aufweisend mindestens eine weitere elektrisch isolierende Schichtstruktur (126), welche mit einer Außenfläche (128) von mindestens einem von der mindestens einen elektrisch isolierenden Schichtstruktur (104), der mindestens einen elektrisch leitfähigen Schichtstruktur (102), und dem weiteren stark thermisch leitfähigen Material (109) verbunden ist, wobei die mindestens eine weitere elektrisch isolierende Schichtstruktur (126) planar ist.

5. Der Komponententräger (100) gemäß einem beliebigen der Ansprüche 1 bis 4, wobei eine maximale horizontale Dicke, C, der Durchgangsöffnung (106) mindestens 100 $\mu$m ist.

6. Der Komponententräger (100) gemäß den Ansprüchen 1 bis 5, wobei eine maximale Tiefe (L) von mindestens einer der Aussparung (110) und der weiteren Aussparung (112) mindestens 100 $\mu$m ist.

7. Der Komponententräger (100) gemäß den Ansprüchen 1 bis 6, wobei das stark thermisch leitfähige Material (108) ein weiteres Netz (134) bei der Ebene (116) der äußeren Fläche (114) der mindestens einen elektrisch isolierenden Schichtstruktur (104) hat, wobei das weitere Netz (134) in einer horizontalen Richtung dem Netz (118) gegenüberliegt, so dass die Aussparung (110) zwischen dem Netz (118) und dem weiteren Netz (134) positioniert ist.

8. Der Komponententräger (100) gemäß Anspruch 7, wobei das weitere Netz (134) eine Breite, I, bei der Ebene (116) der äußeren Fläche (114) der mindestens einen elektrisch isolierenden Schichtstruktur (104) hat, welche die Bedingungen B > I und I > B/20, insbesondere I > B/10 erfüllt.

9. Der Komponententräger (100) gemäß Anspruch 7 oder 8, wobei das Netz (118) und das weitere Netz (134) symmetrisch in Bezug auf eine vertikale Ebene (136) angeordnet sind, welche sich durch eine zentrale Achse der Durchgangsöffnung (106) erstreckt.

**10.** Der Komponententräger (100) gemäß den Ansprüchen 1 bis 9, wobei das stark thermisch leitfähige Material (108) in der Durchgangsöffnung (106) über das Netz (118) mit einem weiteren stark thermisch leitfähigen Material (109) kontinuierlich verbunden ist, welches zumindest einen Teil einer Hauptoberfläche der mindestens einen elektrisch isolierenden Schichtstruktur (104) bedeckt.

**11.** Der Komponententräger (100) gemäß Anspruch 10, wobei das weitere stark thermisch leitfähige Material (109) als eine Schicht geformt ist, welche mittels der Aussparung (110) unterbrochen ist.

**12.** Der Komponententräger (100) gemäß den Ansprüchen 1 bis 11, aufweisend mindestens eines der folgenden Merkmale:

die mindestens eine elektrisch leitfähige Schichtstruktur (102) weist mindestens eines aus der Gruppe auf, bestehend aus Kupfer, Aluminium, Nickel, Silber, Gold, Palladium und Wolfram, wobei jedes der genannten Materialien optional mit einem supra-leitfähigen Material beschichtet ist, zum Beispiel Graphen;
die mindestens eine elektrisch isolierende Schichtstruktur (104) weist mindestens eines aus der Gruppe auf, bestehend aus Harz, insbesondere verstärktem oder nicht verstärktem Harz, zum Beispiel Epoxidharz oder Bismaleinimid-Triazin Harz, FR-4, FR-5, Cyanatester, Polyphenylen Derivat, Glas, Prepreg Material, Polyimid, Polyamid, flüssigkristallinem Polymer, epoxidbasierter Aufbaufolie, Polytetrafluorethylen, einer Keramik, und einem Metalloxid;
der Komponententräger (100) weist mindestens eine eingebettete und/oder mindestens eine oberflächenmontierte Komponente auf, wobei die mindestens eine Komponente insbesondere aus einer Gruppe ausgewählt ist, bestehend aus einer elektronischen Komponente, einem elektrisch nicht leitfähigen und/oder elektrisch leitfähigen Inlay, einer Wärmeübertragungseinheit, einer Energy Harvesting Einheit, einer aktiven elektronischen Komponente, einer passiven elektronischen Komponente, einem elektronischen Chip, einer Speichervorrichtung, einem Filter, einem integrierten Schaltkreis, einer Signalverarbeitungskomponente, einer Leistungsmanagement Komponente, einem optoelektronischen Schnittstellenelement, einem Spannungswandler, einer kryptographischen Komponente, einem Sender und/oder Empfänger, einem elektromechanischen Transducer, einem Aktuator, einem mikroelektromechanischen System, einem Mikroprozessor, einem Kondensator, einem Widerstand, einer Induktanz, einem Akkumulator, einem Schalter, einer Kamera, einer Antenne, einem magnetischen Element, einem lichtleitenden Element, einem weiteren Komponententräger (100), und einem Logikchip;
der Komponententräger (100) ist plattenförmig;
der Komponententräger (100) ist als eine gedruckte Leiterplatte oder ein IC Substrat konfiguriert.

**13.** Ein Verfahren zum Herstellen eines Komponententrägers (100), wobei das Verfahren aufweist:

Bilden eines Stapels (132), welcher mindestens eine elektrisch leitfähige Schichtstruktur (102) und mindestens eine elektrisch isolierende Schichtstruktur (104) aufweist;
Bilden einer Durchgangsöffnung (104), welche sich durch die mindestens eine elektrisch isolierende Schichtstruktur (104) erstreckt;
Füllen, mittels einer Plattierungsprozedur, nur eines Teils der Durchgangsöffnung (106) mit einem stark thermisch leitfähigen Material (108), so dass eine Aussparung (110) gebildet wird, welche nicht mit dem stark thermisch leitfähigen Material (108) gefüllt ist, und eine weitere Aussparung (112), welche nicht mit dem stark thermisch leitfähigen Material (108) gefüllt ist, der Aussparung (110) gegenüberliegend gebildet wird, wobei sich die Aussparung (110) von einer äußeren Fläche (114) der mindestens einen elektrisch isolierenden Schichtstruktur (104) in die Durchgangsöffnung (106) erstreckt, und sich die weitere Aussparung (112) mindestens von einer anderen äußeren Fläche (120) der mindestens einen elektrisch isolierenden Schichtstruktur (104) in die Durchgangsöffnung (106) erstreckt,
wobei das stark thermisch leitfähige Material (108) Kupfer ist;
wobei das Füllen so ausgeführt wird, dass ein Durchmesser, B, der Aussparung (110) bei einer Ebene (116) der äußeren Fläche (114) der mindestens einen elektrisch isolierenden Schichtstruktur (104), und eine Breite, A, eines Netzes (118) des stark thermisch leitfähigen Materials (108) bei der Ebene (116) der äußeren Fläche (114) der mindestens einen elektrisch isolierenden Schichtstruktur (104) die Bedingungen B > A und A > B/20 erfüllen,
**dadurch gekennzeichnet, dass**
das Füllen so ausgeführt wird, dass ein Verhältnis zwischen einem vertikalen Abstand, G, zwischen einem innersten Ende (152) der Aussparung (110) und einem innersten Ende (154) der weiteren Aussparung (112) einerseits und einer Höhe, D, der Durchgangsöffnung (106) andererseits in einem Bereich zwischen 30 % und 95 % ist, insbesondere in einem Bereich zwischen 50 % und 60 % ist.

14. Das Verfahren gemäß Anspruch 13, aufweisend mindestens eines der folgenden Merkmale:

wobei das Verfahren aufweist
Bilden der Durchgangsöffnung (106) mittels mechanischen Bohrens durch die mindestens eine elektrisch isolierende Schichtstruktur (104);
wobei das Verfahren aufweist
Füllen der Durchgangsöffnung (106) nur teilweise mit dem stark thermisch leitfähigen Material (108) mittels Ausführens einer Mehrzahl von Plattierungsprozeduren, wobei die Plattierungsprozeduren beendet werden, sobald die Bedingungen B > A und A > B/20 erfüllt sind.

## Revendications

1. Un support de composants (100), dans lequel le support de composants (100) comprend :

au moins une structure en couche (102) électriquement conductrice et au moins une structure en couche (104) électriquement isolante ;
un trou traversant (106) s'étendant à travers ladite au moins une structure en couche (104) électriquement isolante ;
un matériau (108) hautement conducteur thermiquement, remplissant seulement une partie du trou traversant (106) de sorte qu'un évidement (110) est formé, qui n'est pas rempli du matériau (108) hautement conducteur thermiquement et qui s'étend au moins à partir d'une face extérieure (114) de ladite au moins une structure en couche (104) électriquement isolante dans le trou traversant (106) ;
le matériau (108) hautement conducteur thermiquement étant du cuivre, qui a été introduit dans le trou traversant (106) au moyen d'une procédure de placage ;
un diamètre, B, de l'évidement (110) au niveau (116) de la face extérieure (114) de ladite au moins une structure en couche (104) électriquement isolante et une largeur, A, d'une bande (118) du matériau (108) hautement conducteur thermiquement au niveau (116) de la face extérieure (114) de ladite au moins une structure en couche (104) électriquement isolante, remplissant les conditions B>A et A>B/20 ; et
un autre évidement (112) étant formé dans le matériau (108) hautement conducteur thermiquement de façon opposée à l'évidement (110), ledit autre évidement (112) n'étant pas rempli du matériau (108) hautement conducteur thermiquement et s'étendant au moins à partir d'une autre face extérieure (120) de ladite au moins une structure en couche (104) électriquement isolante dans le trou traversant (106),
**caractérisé en ce que**
un rapport entre une distance verticale, G, entre une extrémité la plus à l'intérieur (152) de l'évidement (110) et une extrémité la plus à l'intérieur (154) dudit autre évidement (112), d'une part, et une hauteur, D, du trou traversant (106), d'autre part, est compris entre 30 % et 95 %, en particulier est compris entre 50 % et 60 %.

2. Le support de composants (100) selon la revendication 1, comprenant au moins une des caractéristiques suivantes :

A>B/10, en particulier A>B/5 ;
un rapport entre une hauteur verticale, D, et une épaisseur horizontale maximale, C, du trou traversant (106) est compris entre 1 et 15, en particulier compris entre 1,5 et 10 ;
le trou traversant (106) est de forme cylindrique sensiblement circulaire ;
une épaisseur de ladite au moins une structure en couche (104) électriquement isolante à travers laquelle le trou traversant (106) s'étend est supérieure à 400 μm, en particulier est comprise entre 600 μm et 2000 μm ;
une valeur de la conductivité thermique du matériau (108) hautement conducteur thermiquement est d'au moins 50 W/mK, en particulier d'au moins 100 W/mK, plus particulièrement d'au moins 200 W/mK.

3. Le support de composants (100) selon la revendication 1 ou la revendication 2, comprenant au moins une des caractéristiques suivantes :

un diamètre, E, dudit autre évidement (112) à un niveau (140) de l'autre face extérieure (120) de ladite au moins une structure en couche (104) électriquement isolante et une largeur, F, d'une autre bande (148) du matériau (108) hautement conducteur thermiquement au niveau (140) de l'autre face extérieure (120) de ladite au moins une structure en couche (104) électriquement isolante remplissent les conditions E>F et F>E/20, en notamment F>E/10, B étant en particulier sensiblement égal à E et/ou A étant sensiblement égal à F ;
le matériau (108) hautement conducteur thermiquement, avec l'évidement (110) et avec ledit autre évidement (112), forment une structure symétrique par rapport à un plan horizontal (122) s'étendant à travers un centre de ladite au moins une structure en couche (104) électriquement isolante à travers laquelle s'étend le trou traversant (106) ;
une section transversale du matériau (108) hautement conducteur thermiquement avec l'évidement (110) et ledit autre évidement (112) le long d'un plan vertical est une structure sensiblement en forme de H.

4. Le support de composants (100) selon l'une quelconque des revendications 1 à 3, comprenant au moins une des caractéristiques suivantes :

au moins un membre du groupe constitué par l'évidement (110) et ledit autre évidement (112) est rempli d'un matériau diélectrique, en particulier au moins un parmi une pâte de bouchage et/ou une résine ;

le fait de comprendre au moins une autre structure en couche (126) électriquement isolante reliée à une surface extérieure (128) d'au moins l'une parmi ladite au moins une structure en couche (104) électriquement isolante, ladite au moins une structure en couche (102) électriquement conductrice, et un autre matériau (109) hautement conducteur thermiquement, ladite au moins une autre structure en couche (126) électriquement isolante remplissant au moins un parmi l'évidement (110) et ledit autre évidement (112), une zone d'une surface principale (130) de ladite au moins une autre structure en couche (126) électriquement isolante qui est en particulier tournée vers au moins un parmi l'évidement (110) et ledit autre évidement (112) étant plus grande, en particulier de 0,1 % à 500 %, qu'une zone hypothétique de ladite surface principale (130) en l'absence de l'évidement (110) ou dudit autre évidement (112) ;

le fait de comprendre au moins une autre structure en couche (126) électriquement isolante reliée à une surface extérieure (128) d'au moins une parmi ladite au moins une structure en couche (104) électriquement isolante, ladite au moins une structure en couche (102) électriquement conductrice et un autre matériau (109) hautement conducteur thermiquement, ladite au moins une autre structure en couche (126) électriquement isolante étant plane.

5. Le support de composants (100) selon l'une quelconque des revendications 1 à 4, dans lequel une épaisseur horizontale maximale, C, du trou traversant (106) est d'au moins 100 µm.

6. Le support de composants (100) selon les revendications 1 à 5, dans lequel une profondeur maximale (L) d'au moins un parmi l'évidement (110) et ledit autre évidement (112) est d'au moins 100 µm.

7. Le support de composants (100) selon les revendications 1 à 6, dans lequel le matériau (108) hautement conducteur thermiquement comporte une autre bande (134) au niveau (116) de la face extérieure (114) de ladite au moins une structure (104) en couche isolante électriquement, ladite autre bande (134) étant agencée à l'opposé de la bande (118) dans une direction horizontale de sorte que l'évidement (110) est situé entre la bande (118) et ladite autre bande (134).

8. Le support de composants (100) selon la revendication 7, dans lequel ladite autre bande (134) a une largeur, I, au niveau (116) de la face extérieure (114) de ladite au moins une structure en couche (104) électriquement isolante remplissant les conditions B>I et I>B/20, notamment I>B/10.

9. Le support de composants (100) selon la revendication 7 ou la revendication 8, dans lequel la bande (118) et ladite autre bande (134) sont agencées symétriquement par rapport à un plan vertical (136) s'étendant à travers un axe central du trou traversant (106).

10. Le support de composants (100) selon les revendications 1 à 9, dans lequel le matériau (108) hautement conducteur thermiquement dans le trou traversant (106) est relié en continu via la bande (118) avec un autre matériau (109) hautement conducteur thermiquement, recouvrant au moins une partie d'une surface principale de ladite au moins une structure en couche (104) électriquement isolante.

11. Le support de composants (100) selon la revendication 10, dans lequel ledit autre matériau (109) hautement conducteur thermiquement est sous la forme d'une couche qui est interrompue par l'évidement (110).

12. Le support de composants (100) selon les revendications 1 à 11, comprenant au moins une des caractéristiques suivantes :

ladite au moins une structure en couche (102) électriquement conductrice comprend au moins un membre du groupe constitué par le cuivre, l'aluminium, le nickel, l'argent, l'or, le palladium et le tungstène, l'un quelconque des matériaux mentionnés étant optionnellement revêtu d'un matériau supraconducteur tel que du graphène ;

ladite au moins une structure en couche (104) électriquement isolante comprend au moins un membre du groupe constitué par de la résine, en particulier une résine renforcée ou non renforcée, par exemple une résine époxy ou une résine bismaléimide-triazine, FR-4, FR-5, un cyanate ester, un dérivé de polyphénylène, du verre, un matériau pré-imprégné, un polyimide, un polyamide, un polymère à cristaux liquides, un film de construction à base d'époxy, du polytétrafluoroéthylène, une céramique et un oxyde métallique ;

le support de composants (100) comprend au moins un composant encastré et/ou au moins un composant monté en surface, ledit au moins un composant étant en particulier choisi dans un groupe constitué par un composant électronique, un composant électriquement non conducteur et/ou un inlay électriquement conducteur, une unité de transfert de chaleur, une unité de récupération d'énergie, un composant électronique actif, un composant électronique passif, une puce électronique, un dispositif de stockage, un filtre, un circuit intégré, un composant de traitement du signal, un composant de gestion de l'alimentation, un élément d'interface optoélectronique, un convertisseur de tension, un composant cryptographique, un émetteur et/ou récepteur, un transducteur électromécanique, un actionneur, un système microélectromécanique, un microprocesseur, un condensateur, une résistance, une inductance, un accumulateur, un interrupteur, une caméra, une antenne, un élément magnétique, un élément de guidage de lumière, un autre support de composants (100) et une puce logique ;

le support de composants (100) est sous la forme d'une plaque ;

le support de composants (100) est configuré en tant qu'une carte à circuit imprimé ou qu'un substrat CI.

13. Un procédé de fabrication d'un support de composants (100), le procédé comprenant :

le fait de former un empilement (132) comprenant au moins une structure en couche (102) électriquement conductrice et au moins une structure en couche (104) électriquement isolante ;

le fait de former un trou traversant (106) s'étendant à travers ladite au moins une structure en couche (104) électriquement isolante ;

le fait, au moyen d'une procédure de placage, de remplir seulement une partie du trou traversant (106) avec un matériau (108) hautement conducteur thermiquement de sorte qu'un évidement (110) est formé qui n'est pas rempli avec le matériau (108) hautement conducteur thermiquement, et un autre évidement (112), qui n'est pas rempli du matériau (108) hautement conducteur thermiquement, est formé à l'opposé de l'évidement (110), l'évidement (110) s'étendant au moins à partir d'une face extérieure (114) de ladite au moins une structure en couche (104) électriquement isolante dans le trou traversant (106) et ledit autre évidement (112) s'étendant au moins à partir d'une autre face extérieure (120) de ladite au moins une structure en couche (104) électriquement isolante dans le trou traversant (106), le matériau (108) hautement conducteur thermiquement étant du cuivre ;

le remplissage étant réalisé de telle sorte qu'un diamètre, B, de l'évidement (110) à un niveau (116) de la face extérieure (114) de ladite au moins une structure en couche (104) électriquement isolante et une largeur, A, d'une bande (118) du matériau (108) hautement conducteur thermiquement au niveau (116) de la face extérieure (114) de ladite au moins une structure en couche (104) électriquement isolante, remplissent les conditions B>A et A>B/20, **caractérisé en ce que**

le remplissage est réalisé de sorte qu'un rapport entre une distance verticale, G, entre une extrémité la plus à l'intérieur (152) de l'évidement (110) et une extrémité la plus à l'intérieur (154) dudit autre évidement (112), d'une part, et une hauteur, D, du trou traversant (106), d'autre part, est compris entre 30% et 95%, en particulier est compris entre 50% et 60%.

14. Le procédé selon la revendication 13, comprenant au moins une des caractéristiques suivantes :

le procédé comprend le fait de former le trou traversant (106) par perçage mécanique à travers ladite au moins une structure en couche (104) électriquement isolante ;

le procédé comprend le fait de remplir seulement partiellement le trou traversant (106) avec le matériau (108) hautement conducteur thermiquement en mettant en oeuvre une pluralité de procédures de placage, les procédures de placage étant terminées dès que les conditions B>A et A>B/20 sont remplies.

Fig. 1

Fig. 2

Fig. 3

Fig. 4

Fig. 5

Fig. 6

**EP 3 570 645 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2518187 A1
- US 2004124535 A1

- WO 2006032346 A1